# EUROPEAN PATENT APPLICATION

(11) **EP 1 923 730 A1**
(43) Date of publication of application: **21.05.2008**
(21) Application number: 07021825.0
(22) Date of filing: 09.11.2007
(51) Int. Cl.: G02B 26/08, G02B 26/06, G02B 7/185, H01L 41/083, B81B 3/00

(54) **Deformable mirror**

(30) Priority: 17.11.2006 JP 2006310922
(71) Applicant: Funai Electric Co., Ltd., Daito-shi Osaka 574-0013 (JP)
(72) Inventor: Tanaka, Fuminori, Daito-shi Osaka 574-0013 (JP); Maeda, Shigeo, Daito-shi Osaka 574-0013 (JP)
(74) Representative: Beetz & Partner

(57) **Abstract**

A deformable mirror includes a mirror substrate having a mirror surface, a supporting member that support the mirror substrate and has a through hole extending in the direction substantially perpendicular to the mirror substrate, an electrode portion that is disposed on the underside of the supporting member opposite to the surface for supporting the mirror substrate so as to cover at least a part of the through hole, and an actuator that is inserted in the through hole and is bonded and fixed to the electrode portion, the actuator being expanded and contracted so as to deform the mirror surface as well as the mirror substrate when electric power is supplied via the electrode portion.

## Description

### BACKGROUND OF THE INVENTION

### Field of the Invention

The present invention relates to a deformable mirror that is provided to an optical system of an optical disc apparatus, a digital camera, a projector or other optical devices and can perform correction of optical distortion of an incident light beam by changing a shape of its mirror surface.

### Description of Related Art

Conventionally, there are various proposals about the deformable mirror that can correct optical distortion or the like of an incident light beam by changing the shape of its mirror surface. For example, JP-A-H02-166403 discloses a deformable mirror including a supporting member made of a rigid body, an insulation supporting member having softness or flexibility to some extent, which is supported on the supporting member, a mirror supported on the insulation supporting member, a plurality of piezoelectric rods connecting the mirror with the rigid body supporting member. This deformable mirror can form a desirable curved surface of the mirror by applying voltages to the piezoelectric rods so that the piezoelectric rods expand and contract. In addition, JP-A-H05-333274 also discloses a deformable mirror that can deform its mirror surface by utilizing expansion and contraction of column-shaped piezoelectric actuators in the direction perpendicular to the mirror surface.

However, the deformable mirror disclosed in JP-A-H02-166403 or JP-AH05-333274 has a disadvantage that it is difficult to downsize the entire device. Therefore, as disclosed in JP-A-2004-347753, there is proposed a variable shape mirror element (deformable mirror) that is manufactured by forming thin films including a piezoelectric film. In the case of the variable shape mirror element disclosed in JP-A-2004-347753, there is an advantage that the mirror can be downsized particularly in its thickness direction, since it is made up of thin films. However, since a driving force for deforming the mirror is obtained from the piezoelectric film, it has a disadvantage that it is difficult to obtain sufficient displacement of the mirror.

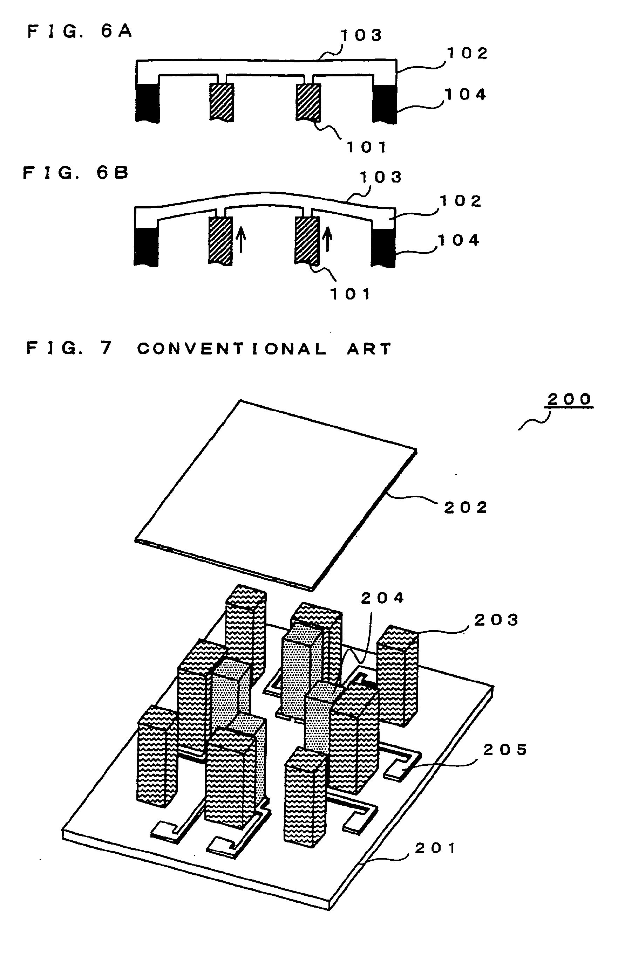

Under the circumstances described above, the inventors have been developing a deformable mirror that can control the shape variation of its mirror surface 103 by deforming a mirror 102 utilizing expansion and contraction of actuators 101 in the direction (the direction shown by arrows) perpendicular to the mirror surface as shown in Figs. 6A and 6B. According to the deformable mirror, an advantage to be able to increase displacement of the mirror can be made use of. Note that Figs. 6A and 6B are schematic diagrams for explaining a principle of deforming the mirror surface 103 of the deformable mirror. Fig. 6A shows the state before the mirror surface 103 is deformed, while Fig. 6B shows that state after the mirror surface 103 is deformed. In Figs. 6A and 6B, numeral 104 denotes a supporting column for fixing the mirror 102.

However, the deformable mirror that changes the shape of the mirror surface 103 by utilizing expansion and contraction of the column-shaped actuator 101 has a problem that a size of the device becomes large as mentioned above as the problem of the deformable mirror disclosed in JP-A-H02-166403 or JP-A-H05-333274. Other than that, it has various problems including that manufacturing of the device is not easy. Hereinafter, these problems will be described in detail with reference to Fig. 7 that shows a structure of the conventional deformable mirror.

Fig. 7 is an exploded perspective view showing a structure of a conventional deformable mirror 200. The deformable mirror 200 is equipped with a base 201, a mirror 202 disposed so as to be opposed to the base 201, supporting columns 203 formed on the base 201 so as to support the mirror 202, and an actuator 204 that deforms the mirror surface by deforming the mirror 202 with an expansion and contraction. The actuator 204 is made of a piezoelectric element, to which electric power is supplied via a wiring pattern 205 formed on the base 201.

As for the deformable mirror 200 having the structure described above, thickness of the base 201 in particular should be large for securing sufficient rigidity. Therefore, there is a problem of a size of the device becomes large in the thickness direction. In addition, there is another reason for the necessity of increasing the thickness of the base 201. In other words, it is necessary to laminate a substrate made of silicon or the like to be the wiring pattern 205 to the base 201 for forming the wiring pattern 205 on the base 201. In this case, if the thickness of the base 201 is thin, the base 201 may be warped easily resulting in poor handling property when the silicon for forming the wiring pattern 205 is laminated on the base 201. For this reason, the thickness of the base 201 is increased to some extent.

Further in the deformable mirror 200, since it is difficult to draw out wires from the actuator 204 by means of wire bonding or the like, the wiring pattern 205 is formed for supplying electric power to the actuator 204. In this case, a space on the base 201 for forming the wiring pattern 205 is necessary. Therefore, an area of the base 201 may increase, and a size of the deformable mirror may increase.

In addition, due to this existing wiring pattern 205, it is difficult to make a plate surface of the base 201 have the same area as the plate surface of the mirror 202 has. Therefore, in the manufacturing process of the deformable mirror, it becomes difficult to separate the devices from each other after the assembly process. For example, there is a problem that if cutting is performed by using a dicing saw to adapt to a size of the base 201, breakage may occur easily during cutting, since the part between the mirror 202 and the base 201 is hollow at the periphery of the mirror 202.

Further in the case of the structure of the deformable mirror 200, the supporting column 203 and the actuator 204 should be positioned for bonding them to the base 201. In this case, a jig for positioning them in the manufacturing process is necessary, and there is a problem that the manufacturing process becomes complicated because attaching and detaching steps of the jig are necessary.

### SUMMARY OF THE INVENTION

An object of the present invention is to provide a deformable mirror that can increase displacement of the mirror and can be manufactured easily into a compact size.

A deformable mirror of the present invention includes a mirror substrate having a mirror surface, a supporting member that support the mirror substrate and has a through hole extending in the direction substantially perpendicular to the mirror substrate, an electrode portion that is disposed on the underside of the supporting member opposite to the surface for supporting the mirror substrate so as to cover at least a part of the through hole, and an actuator that is inserted in the through hole and is bonded and fixed to the electrode portion, the actuator being expanded and contracted so as to deform the mirror surface as well as the mirror substrate when electric power is supplied via the electrode portion.

According to this structure, since the electrode portion for supplying electric power to the actuator is formed on the supporting member for supporting the mirror substrate and the actuator is bonded and fixed to the electrode portion, there is no need to use a substrate that is necessary for forming an electrode pattern in the conventional structure so that the thickness of the device can be reduced. In addition, since electric power can be supplied to the actuator easily via the electrode portion formed on the supporting member, increase of size of the device due to the wiring pattern can be avoided so that the deformable mirror can be downsized. In addition, since the actuator can be positioned by the through hole formed in the supporting member, there is no need to use a jig that is necessary in the conventional manufacturing process so that the manufacturing process can be simplified. In addition, since the mirror substrate is deformed by expansion and contraction of the actuator, deformation of the mirror surface can be increased.

Furthermore as for the present invention, in the deformable mirror having the structure described above, the supporting member is preferably formed of an insulating rigid body.

According to this structure, since the supporting member is formed of an insulating rigid body, deformation of the mirror surface can be increased easily.

Furthermore as for the present invention, in the deformable mirror having the structure described above, the actuator is preferably a piezoelectric actuator including a piezoelectric material and electrodes.

According to this structure, since the actuator is the piezoelectric actuator, it can be realized easily.

Furthermore as for the present invention, in the deformable mirror having the structure described above, the piezoelectric actuator is preferably a laminated piezoelectric actuator including a plurality of layers of piezoelectric material and a plurality of layers of electrodes that are laminated alternately.

According to this structure, since the piezoelectric actuator is the laminated piezoelectric actuator, a generated force can be increased and deformation of the mirror surface can be increased.

Furthermore as for the present invention, in the deformable mirror having the structure described above, it is possible to adopt a structure in which the layers of electrodes are connected alternately to a first common electrode and a second common electrode that are disposed on side faces that are substantially parallel to the lamination direction of the piezoelectric actuator so as to be different polarities of electrodes alternately, each of the first common electrode and the second common electrode is connected electrically to a bonding surface of the piezoelectric actuator which is bonded to the electrode portion, and the electrode portion is provided with an electrode for supplying electric power to the first common electrode and an electrode for supplying electric power to the second common electrode.

According to this structure, two electrode are formed on the electrode portion that is formed on the supporting member, and electric power is supplied to the piezoelectric actuator via the two electrodes so as to drive the piezoelectric actuator. Therefore, wiring for supplying electric power to the actuator is not complicated.

Furthermore as for the present invention, in the deformable mirror having the structure described above, the mirror substrate preferably has the same shape and the same size as the supporting member in a plan view.

According to this structure, since the mirror substrate has the same shape and the same size as the supporting member in a plan view, separation of the device after the assembling process can be performed easily.

### BRIEF DESCRIPTION OF THE DRAWINGS

Fig. 1 is an exploded perspective view showing a structure of a deformable mirror according to the present embodiment.
Fig. 2 is a general plan view showing a structure of the deformable mirror according to the present embodiment, which is a diagram viewed from the bottom side of Fig. 1.
Fig. 3 is a general cross section of the deformable mirror shown in Fig. 1 in the assembled state cut along the line III-III.
Fig. 4 is a general cross section showing a structure of an actuator provided to the deformable mirror according to the present embodiment.
Fig. 5 is a plan view of the mirror substrate showing a position where the mirror substrate is bonded to a supporting member.
Fig. 6A is a schematic diagram for explaining a principle of deforming a mirror surface of the deformable mirror, which shows the state before the mirror surface is deformed.
Fig. 6B is a schematic diagram for explaining a principle of deforming a mirror surface of the deformable mirror, which shows the state after the mirror surface is deformed.
Fig. 7 is an exploded perspective view showing a structure of a conventional deformable mirror.

### DETAILED DESCRIPTION OF THE PREFERRED EMBODIMENTS

Hereinafter, an embodiment of the present invention will be described with reference to the attached drawings. Note that the embodiment described here is an example, and the present invention is not limited to the embodiment described here. In addition, sizes, thicknesses and the like in the drawings are shown for a purpose of facilitating understanding, so they do not always match the actual structure.

### (Structure of deformable mirror)

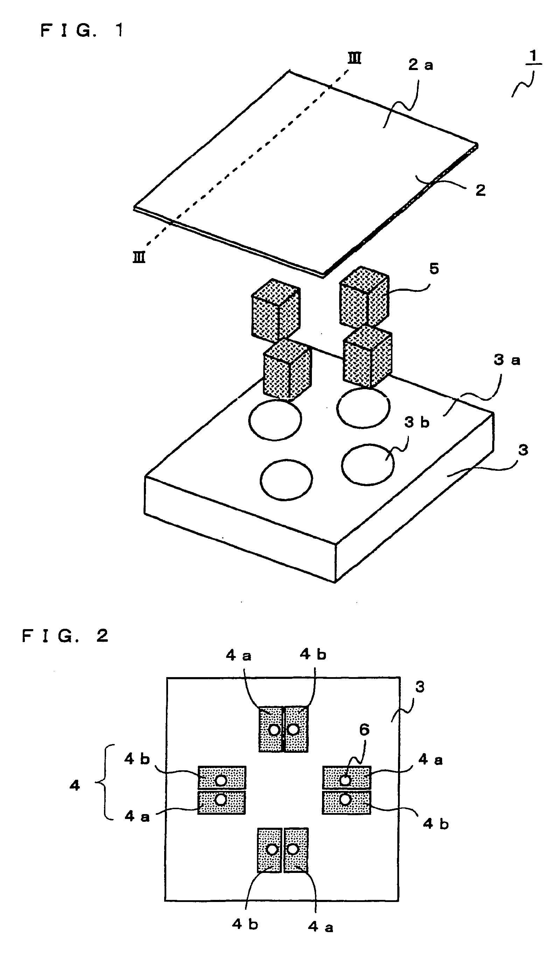

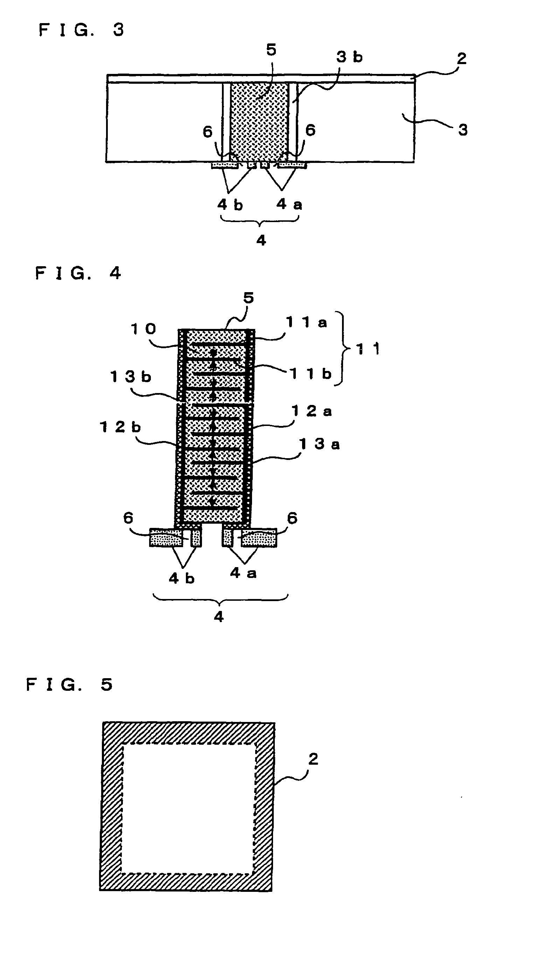

Fig. 1 is an exploded perspective view showing a structure of a deformable mirror according to the present embodiment. Fig. 2 is a general plan view showing a structure of the deformable mirror according to the present embodiment, which is a diagram viewed from the bottom side of Fig. 1. Fig. 3 is a general cross section of the deformable mirror shown in Fig. 1 in the assembled state cut along the line III-III. Fig. 4 is a general cross section showing a structure of an actuator provided to the deformable mirror according to the present embodiment. Note that Fig. 4 also shows electrode portions at which the actuator is bonded and fixed. Hereinafter, the deformable mirror according to the present embodiment will be described with reference to Figs. 1 to 4 mainly.

Numeral 1 denotes the deformable mirror, which can correct optical distortion of an incident light beam by changing a shape of its mirror surface. This deformable mirror 1 includes a mirror substrate 2 having a mirror surface 2a, a supporting member 3 that supports the mirror substrate 2, electrode portions 4 formed on the underside of a surface 3a of the supporting member 3 that supports the mirror substrate 2, actuators 5 that are inserted in through holes 3b formed in the supporting member 3 and are bonded and fixed to the electrode portions 4. Hereinafter, the individual portions will be described in detail.

The mirror substrate 2 is deformed when the actuators 5 press the same by their expansion and contraction, so that a shape of its mirror surface 2a is deformed. Therefore, the thickness of the mirror substrate 2 should be thin so that it can be deformed by expansion and contraction of the actuator 5. On the other hand, it is required to have rigidity to some extent so as not to be broken in the deformation by expansion and contraction of the actuator 5. Considering this point, the mirror substrate 2 is made of a silicon (Si) substrate in the present embodiment, and the thickness of silicon substrate is approximately 100 microns.

Although silicon is used as a material constituting the mirror substrate 2 in the present embodiment, the present invention is not limited to this structure. It is possible to use other material as long as it can be thin and has rigidity to some extent. In addition, the thickness of the silicon substrate constituting the mirror substrate 2 is not limited to the value in the present embodiment but can be modified in accordance with its purpose or the like.

The mirror surface 2a of the mirror substrate 2 is obtained by forming an aluminum (Al) layer on the mirror substrate 2. The Al layer is formed by vapor deposition, sputtering or the like. Note that the material of the mirror surface 2a is not limited to aluminum but can be one of other various materials such as gold (Au), silver (Ag) or the like, as long as it can provide a desired reflection factor with respect to reflection light of the light beam entering the mirror surface 2a of the deformable mirror 1. In addition, although the entire upper surface of the mirror substrate 2 is used as the mirror surface 2a in the present embodiment, the present invention is not limited to this structure. It is possible to adopt another structure in which the reflection layer is formed in a limited area of the mirror surface 2a considering an incident diameter of the incident light beam or other structures.

The supporting member 3 has a role of supporting the mirror substrate 2 as it is bonded to the mirror substrate 2. This supporting member 3 is formed in a rectangular solid shape having the same shape and the same size as the rectangular mirror substrate 2 when it is viewed from the top (from the mirror surface 2a). The position where the mirror substrate 2 is bonded to the supporting member 3 is a peripheral position with hatching as shown in Fig. 5. Since the supporting member 3 is bonded to the mirror substrate 2 only at the peripheral part, the mirror substrate 2 can be deformed when the actuators 5 are expanded and contracted inside the bonded part. Note that Fig. 5 is a plan view of the mirror substrate 2 showing the position where the mirror substrate 2 is bonded to the supporting member 3.

The supporting member 3 is bonded to the mirror substrate 2 by anodic bonding, for example. Note that without limited to the anodic bonding other methods can be used for the bonding. For example, it is possible to use a method of using adhesive, or a thermo compression bonding method in which an Au layer to be a bonding layer is placed between the supporting member 3 and the mirror substrate 2, and a pressure is applied under a high temperature within a range of 400 to 550 degrees centigrade, for example. If the thermo compression bonding method is used, the bonding layer can be other metal layer or an alloy layer instead of the Au layer. For example, an Al layer, a Sn layer, an Au-Sn alloy layer or the like can be used.

In addition, the supporting member 3 is provided with four through holes 3b extending in the direction substantially perpendicular to the mirror substrate 2. The four through holes 3b are adapted to house the actuators 5. Note that positions of the through holes 3b are decided so that the housed actuators 5 are positioned in a cross direction passing through the center of the supporting member 3 and that they are symmetric with respect to the center of the supporting member 3.

The supporting member 3 is made of an insulating material that is a glass in the present embodiment. However, it is not limited to a glass but can be a ceramic or the like. In addition, the supporting member 3 is preferably a rigid body to make a deformation of the mirror substrate 2 large, which is deformed by expansion and contraction of the actuators 5. From this viewpoint too, the supporting member 3 is preferably made of a glass or a ceramic.

The plurality of electrode portions 4 are provided to the underside of the surface 3a of the supporting member 3 that supports the mirror substrate 2 so as to cover the through holes 3b. The electrode portion 4 may be provided so as to cover a part or a whole of the area of the through hole 3b. In other words, the electrode portion 4 is provided to the underside of the surface 3a of the supporting member 3 that supports the mirror substrate 2 at the position that enables the actuator 5 inserted in the through hole 3b can be bonded and supported (see Fig. 2). In the present embodiment, the electrode portion 4 includes a positive electrode 4a and a negative electrode 4b that constitute a pair for one electrode portion 4, and the deformable mirror 1 is equipped with four electrode portions 4.

The electrode portion 4 is formed by bonding a silicon substrate to the supporting member 3, for example, by anodic bonding or by using adhesive. In addition, a surface of each of silicon of the positive electrode 4a and the negative electrode 4b is provided with a conductive material formed by vapor deposition or the like for example, while through holes 6 where a conducive material is formed in the inside by plating or the like are provided to each of silicon of the positive electrode 4a and the negative electrode 4b. Since the positive electrode 4a and the negative electrode 4b are structured as described above, electric power can be supplied to the actuator 5 externally.

Although electric power can be supplied to the actuator 5 externally via a through hole 6 in the present embodiment, the present invention is not limited to this structure. For example, it is possible to adopt another structure in which via holes filled with a conductive material are provided. In addition, although the electrode portion 4 has a function as an electrode with the conductive material formed on the surface of silicon of the electrode portion 4 and the through holes 6 in the present embodiment, it is possible of course that the electrode portion 4 is made of a conductive material so as to have a function as an electrode.

The actuator 5 is a so-called laminated piezoelectric actuator, which can control expansion and contraction of its piezoelectric material by adjusting a voltage that is applied to the piezoelectric material. The actuator 5 is inserted in the through hole 3b formed in the supporting member 3 and bonded and fixed to the electrode portion 4.

The actuator 5 has a structure in which layers of a piezoelectric material 10 and layers of internal electrodes 11 are laminated alternately as shown in Fig. 4. The internal electrodes 11 include two types that include internal electrodes 11a and internal electrodes 11b. The internal electrodes 11 a are connected to a first common electrode 12a disposed on a side surface of the actuator 5, and the internal electrodes 11 b are connected to a second common electrode 12b disposed on another side surface of the actuator 5 that is opposed to the side surface on which the first common electrode 12a is disposed. In other words, the internal electrodes 11 provided to the actuator 5 include different polarities (positive electrodes and negative electrodes) arranged alternately.

Note that the first common electrode 12a is connected electrically to the lower surface of the actuator 5 via a metal film (Au film in the present embodiment) 13a, while the second common electrode 12b is connected electrically to the lower surface of the actuator 5 via a metal film (Au film in the present embodiment) 13b. Therefore, the positive electrode and the negative electrode of the actuator 5 can be drawn out from its lower side.

In addition, the piezoelectric material 10 sandwiched between the internal electrodes 11 a and 11b is processed with polarization treatment so as to be polarized in the direction shown by arrows in Fig. 4. Note that the above-mentioned polarization treatment means a treatment of applying heat and high DC electric field so that electric dipoles inside the piezoelectric material 10 are made uniform in a constant direction for obtaining piezoelectric activity.

The layers of piezoelectric material 10 of the actuator 5 are arranged to have opposite polarization directions alternately. According to this structure, when a voltage is applied to the internal electrodes 11 that include the positive electrode and the negative electrode arranged alternately, all the layers of piezoelectric material 10 are expanded or contracted. Thus, this structure enables to obtain a large displacement (a large generated force) with a low driving power as known.

Note that a voltage is applied so that the first common electrode 12a becomes the positive electrode while the second common electrode 12b becomes the negative electrode, and therefore the piezoelectric material 10 is expanded when the voltage is applied in the present embodiment. Furthermore, expansion and contraction of the actuator 5 is controlled by adjusting the expanded amount of the piezoelectric material 10.

The piezoelectric material 10 is made of lead zirconate titanate (Pb(ZrₓTi₁-ₓ)O₃) that is superior in piezoelectric characteristics. However, a type of the piezoelectric material 10 that constitutes the actuator 5 is not limited to this but can be changed in accordance with its purpose and manufacturing conditions. For example, it may be made of other piezoelectric material such as piezoelectric ceramics including barium titanate (BaTiO₃) or a high polymer including PVDF (polyvinylidene fluoride) or the like, for example.

Bonding between the actuator 5 and the electrode portion 4 is performed, for example, by placing an Au layer to be a bonding layer between the actuator 5 and the electrode portion 4 and applying pressure at a high temperature within 400 to 550 degrees centigrade. In this case, the bonding layer can be other metal layer or an alloy layer instead of the Au layer. For example, an Au-Sn alloy layer or the like can be used.

Note that it is possible to eliminate the step of placing the Au layer between the actuator 5 and the electrode portion 4, because the Au film is formed on the lower surface of the actuator 5 in the case of the present embodiment. However, in order to secure the sufficient bonding, the Au layer may be formed by the vapor deposition method or the sputtering method. Alternatively, Au foil may be placed as the Au layer. Alternatively, it is possible of course to use conductive adhesive for bonding the actuator 5 to the electrode portion 4.

The actuator 5 is not bonded to the mirror substrate 2. The reason why the actuator 5 is not bonded to the mirror substrate 2 is that the mirror surface 2a of the mirror substrate 2 may generate a distortion if the actuator 5 is bonded to the mirror substrate 2, and the distortion should be reduced as much as possible. If the occurrence of the distortion is not a problem, the actuator 5 may be bonded to the mirror substrate 2.

Although four actuators 5 are disposed in the deformable mirror 1 according to the present embodiment, the present invention is not limited to this structure. It is possible to increase the number of through holes 3b formed in the supporting member 3 so that more actuators 5 can be disposed. On the contrary, it is possible to reduce the actuators 5. The structure of the present embodiment has an advantage that the actuators 5 can be disposed in a dense manner so that the number of the actuators 5 can be increased because the wiring pattern is not complicated compared with the conventional structure.

In addition, the height of the actuator 5 is the same as the height of the supporting member 3 in the present embodiment. However, the present invention is not limited to this structure. It is possible that the actuator 5 is higher than the supporting member 3. In this case, even if the actuator 5 is not bonded to the mirror substrate 2, deformation of the mirror substrate 2 can be controlled by both expansion and contraction of the piezoelectric material 10 when a voltage is applied to the actuator 5. Therefore, deformation amount of the mirror surface 2a can be increased.

In addition, although the actuator 5 is the laminated piezoelectric actuator in the present embodiment, the present invention is not limited to this structure. For example, it may be other piezoelectric actuator except the laminated type.

In addition, electric power is supplied to the actuator 5 via the positive electrode 4a and the negative electrode 4b of the electrode portion 4 when the actuator 5 is driven in the present embodiment, the present invention is not limited to this structure, which can be modified within the scope of the present invention without deviating from the object of the present invention. In other words, it is possible to another structure in which only one of the positive electrode and the negative electrode is provided to the electrode portion 4 while the other electrode is provided to the lower surface of the mirror substrate 2, for example. In addition, if deformation of the mirror substrate 2 is controlled by utilizing both expansion and contraction of the piezoelectric material 10 when a voltage is applied to the actuator 5, it is possible to make both the two electrodes disposed at the electrode portion 4 be able to switch between the positive electrode and the negative electrode without fixing one them to the positive electrode and the other to the negative electrode.

Further more, although the entire shape of the deformable mirror 1 described above is a rectangular solid shape, the present invention is not limited to this structure, which can be modified variously within the scope of the present invention without deviating from the spirit of the present invention. For example, the entire shape of the deformable mirror may be a cylindrical shape or the like.

### (Manufacturing method for deformable mirror)

Next, a manufacturing method for the deformable mirror 1 according to the present embodiment will be described. Note that the manufacturing method described here is merely an example, and other method may be adopted for manufacturing it. First, the through holes 3b in which the actuators 5 are inserted are formed in the glass substrate to be the supporting member 3 by an etching process (a first step). Note that the etching process may be dry etching or wet etching.

The silicon substrate to be the electrode portion 4 is bonded to the glass substrate with the through holes 3b by anodic bonding (a second step). Using a lithography method and an etching method, only portions necessary as the electrode portions 4 are left (a third step). Note that the through holes 6 of the electrode portion 4 are also formed on this occasion. The conductive material is formed in the through hole 6 by a plating method or the like.

The Au layer is formed on the surface of the electrode portion 4 by using the vapor deposition method or the sputtering method from the side for inserting the actuator 5 (a fourth step). The actuator 5 is inserted in the through hole 3b, and the actuator 5 is bonded to the electrode portion 4 by the thermo compression bonding method described above (a fifth step). Note that registration of the actuator 5 can be performed by the through hole 3b without using any jig in this case.

The actuator 5 to be inserted in the fifth step is longer than the thickness of the glass substrate to be the supporting member 3. Therefore, the actuator 5 is ground to have the same height as the glass substrate after the actuator 5 is bonded and fixed to the electrode portion 4 (a sixth step). After that, the silicon substrate to be the mirror substrate 2 is bonded to the glass substrate to be the supporting member 3 by anodic bonding (a seventh step). The reflection layer (e.g., A1 layer or the like) is formed on the silicon substrate to be the mirror substrate 2 by the vapor deposition method (an eighth step). Finally, it is cut by the dicing saw to separate each device and to obtain the deformable mirror 1 (a ninth step).

As described above, when the deformable mirror 1 is manufactured, there is no need to use the jig that is necessary for positioning the actuator 5 in the manufacturing process of the conventional deformable mirror 200 (see Fig. 7), so that manufacturing steps can be reduced. In addition, since it is possible to make the mirror substrate 2 have the same shape and the same size as the supporting member 3 in a plan view, there is little possibility of breakage of the device when it is cut by using the dicing saw. Therefore, it is easy to separate the device (deformable mirror) after the assembling process.

The deformable mirror of the present invention can increase a displacement of the mirror and is easy to manufacture in a small size. Therefore, it is useful as a deformable mirror that is disposed in an optical system of an optical device such as an optical disc apparatus, a video projector, a digital camera or the like.

## Claims

1. A deformable mirror comprising:
a mirror substrate having a mirror surface;
a supporting member that support the mirror substrate and has a through hole extending in the direction substantially perpendicular to the mirror substrate;
an electrode portion that is disposed on the underside of the supporting member opposite to the surface for supporting the mirror substrate so as to cover at least a part of the through hole; and
an actuator that is inserted in the through hole and is bonded and fixed to the electrode portion, the actuator being expanded and contracted so as to deform the mirror surface as well as the mirror substrate when electric power is supplied via the electrode portion.

2. The deformable mirror according to claim 1, **characterized in that** the supporting member is formed of an insulating rigid body.

3. The deformable mirror according to claim 1 or 2, **characterized in that** the actuator is a piezoelectric actuator including a piezoelectric material and electrodes.

4. The deformable mirror according to claim 3, **characterized in that** the piezoelectric actuator is a laminated piezoelectric actuator including a plurality of layers of piezoelectric material and a plurality of layers of electrodes that are laminated alternately.

5. The deformable mirror according to claim 4, **characterized in that** the layers of electrodes are connected alternately to a first common electrode and a second common electrode that are disposed on side faces that are substantially parallel to the lamination direction of the piezoelectric actuator so as to be different polarities of electrodes alternately, each of the first common electrode and the second common electrode is connected electrically to a bonding surface of the piezoelectric actuator which is bonded to the electrode portion, and the electrode portion is provided with an electrode for supplying electric power to the first common electrode and an electrode for supplying electric power to the second common electrode.

6. The deformable mirror according to any one of claims 1 to 5, **characterized in that** the mirror substrate has the same shape and the same size as the supporting member in a plan view.
